(19) Europäisches Patentamt
European Patent Office
Office européen des brevets

(11) **EP 3 736 970 A1**

(12) **EUROPEAN PATENT APPLICATION**

(43) Date of publication:
**11.11.2020 Bulletin 2020/46**

(51) Int Cl.:
*H02P 9/00* (2006.01)   *H02P 6/18* (2016.01)
*H02P 101/15* (2016.01)

(21) Application number: **19172847.6**

(22) Date of filing: **06.05.2019**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(71) Applicant: **Siemens Gamesa Renewable Energy A/S**
**7330 Brande (DK)**

(72) Inventor: **Freire, Nuno Miguel Amaral**
**7330 Brande (DK)**

(74) Representative: **Aspacher, Karl-Georg**
**Siemens Gamesa Renewable Energy GmbH & Co. KG**
**Otto-Hahn-Ring 6**
**81739 München (DE)**

(54) **POSITION AND SPEED CALCULATION FOR AN ELECTRIC GENERATOR**

(57)   It is provided a circuit (200) for calculating position and/or speed of a rotor (103) of an electric generator (100). The circuit (200) comprises:
an input port (201) for receiving a vibration input signal (202) representing a cogging torque of the electric generator (100),
a speed observer module (210) connected to the input port (201) and generating a cogging position signal (214) and a cogging frequency signal (215) as outputs,
a rotor speed module (220) receiving the cogging position signal (214) and the cogging frequency signal (215) as inputs and generating a rotor position signal (221) and a rotor speed signal (222) as outputs.

FIG 3

## Description

Field of invention

The present invention relates to a method and to an arrangement for calculating the position and speed of the rotor of an electric generator. Further, the invention relates to a wind turbine comprising an electric generator and the arrangement for calculating the position and speed of the rotor of the electric generator.

Art Background

A wind turbine typically comprises a wind rotor with blades connected thereto and an electric generator, in particular a high power permanent magnet synchronous machine having a generator rotor which is mechanically connected to the wind rotor. A wind turbine may further include a converter connected to the electric generator.

The knowledge of the rotor speed and position is a requirement for controlling a permanent magnet synchronous machine. Estimation methods are usually adopted to avoid extra sensors and to reduce hardware requirements, which are implemented in the converter control system and require the frequency converter to be in operation. In wind turbines, converter operation is typically started above a given rotor speed, the so-called "cut-in speed". As a consequence, additional hardware is usually required for the synchronization of the generator with the converter, namely, a speed sensor and/or voltage sensors. In fact, none of these sensors is required during converter operation, but only to ensure a smooth generator start by avoiding a large torque disturbance as a consequence of an erroneous rotor position. Torque disturbances at start up may be audible, being a concern with regards to noise. Moreover, component fatigue may increase and turbine lifetime decrease.

As a more cost-effective alternative to the above described solution, the present disclosure proposes to estimate speed and position of the rotor without involving signals outputted by speed/position and voltage sensors.

Summary of the Invention

The above described purpose is met by the subject matter according to the independent claims. Advantageous embodiments of the present invention are described by the dependent claims.

According to a first aspect of the present invention it is provided a circuit for calculating position and/or speed of a rotor of an electric generator. The circuit comprises:

an input port for receiving a vibration input signal representing a cogging torque of the electric generator,
a speed observer module connected to the input port and generating a cogging position signal and a cogging frequency signal as outputs,
a rotor speed module receiving the cogging position signal and the cogging frequency signal as inputs and generating a rotor position signal and a rotor speed signal as outputs.

In the context of the present invention, a "circuit" or "module" can be implemented as an hardware circuit and/or a programmable logic circuit configured and arranged for implementing the specified operations/activities. In possible embodiments, a programmable circuit may include one or more computer circuits programmed to execute a set (or sets) of instructions (and/or configuration data). The instructions (and/or configuration data) can be in the form of firmware or software stored in and accessible from a memory (circuit). According to a second aspect of the present invention it is provided a method for calculating position and/or speed of a rotor of an electric generator. The method comprises:

deriving a cogging torque signal of the electric generator from an acceleration input signal,
generating a cogging position signal and a cogging frequency signal based on the cogging torque signal,
scaling and/or off-setting the cogging position signal and the cogging frequency signal for generating a rotor position signal and a rotor speed signal.

The method may be implemented in hardware and/or software and may in particular be performed by a wind turbine controller or in general a generator controller. The generator may in particular be or comprise a permanent magnet synchronous machine, in which plural permanent magnets are attached to a rotor which rotates relative to a stator, the stator having at least one set of stator windings, for example one or more sets of three-phase stator windings. The electric generator may be comprised in a wind turbine.

Advantageously, the present invention permits speed estimation by using an accelerometer signal as an alternative to speed and voltage sensors. An accelerometer may be used, which is installed on the wind turbine for providing also other function, which are independent from the estimation of speed and position of the rotor. For example, an accelerometer is normally required for closed-loop control of torque ripple in a direct drive wind turbine. Therefore the present invention provides the possibility to a reduction of costs. The present invention permits to avoid the direct measurement of the cogging torque by means of load cells and strain gauges, which may be costly and unreliable.

According to embodiments of the present invention, the accelerometer is fixed with respect to a stator of the electric generator. In particular, the accelerometer may be fixed to a stationary ring of rotary bearing of the electric generator. The accelerometer may measure the acceleration in tangential or radial or other direction of the stationary ring of the main bearing of the generator. The vibration signal may comprise one or more higher harmonics of a fundamental electric frequency of the generator, the fundamental frequency being in particular related to a frequency of revolutions of a generator rotor rotating relative to a fixed stator.

Embodiments of the present invention are now described with reference to the accompanying drawings. The invention is not restricted to the illustrated or described embodiments.

The aspects defined above and further aspects of the present invention are apparent from the examples of embodiment to be described hereinafter and are explained with reference to the examples of embodiment. The invention will be described in more detail hereinafter with reference to examples of embodiment but to which the invention is not limited.

Brief Description of the Drawings

Fig. 1 schematically shows a wind turbine according to an embodiment of the present invention;

Fig. 2 schematically shows an arrangement for controlling a generator according to an embodiment of the present invention;

Fig. 3 shows a block diagram for illustrating a circuit and a method according to embodiments of the present invention;

Fig. 4 shows graphs for illustrating the present invention.

Detailed Description

The illustration in the drawings is in schematic form. It is noted that in different figures, similar or identical elements are provided with the same reference signs.

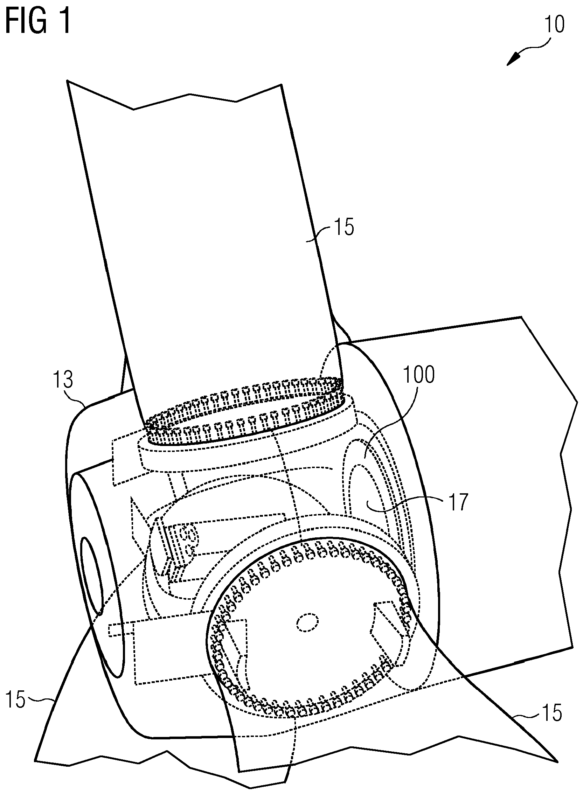

**Fig. 1** illustrates in a partial schematic form a wind turbine 10. The wind turbine comprises a hub 13 to which plural rotor blades 15 are connected. The hub is mechanically connected to a main shaft 17 whose rotation is transformed by an optional gear box to a rotation of a secondary shaft, wherein the gear box may be optional in which case the wind turbine may be a direct drive wind turbine (as shown in fig. 1). The main shaft 17 or the secondary shaft drives a electric generator 100 which may be in particular a synchronous permanent magnet generator providing a power stream to a converter (not shown in the attached figures) for transforming a variable AC power stream from the electric generator 100 to a fixed frequency AC power stream which is to be provided to an utility grid (not shown in the attached figures), which is connected to the converter.

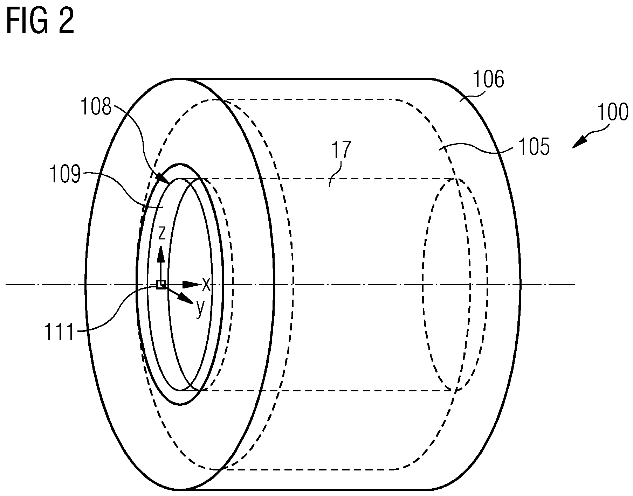

**Fig. 2** schematically illustrates in more detail the generator 100, which includes a stator 105 and a rotor 106 externally arranged with respect to the stator 105. According to other embodiments of the present invention (not shown) the rotor may be internally arranged with respect to the stator 105. The rotor 106 rotates around a rotation axis also defining the axial direction X of the generator 100. Perpendicular to the axial direction X a radial direction Y and a tangential direction Z are defined. The stator 105 is arranged around the rotation axis X and comprises a not illustrated stator yoke having teeth and slots which are spaced apart in the tangential direction Z Around the teeth, plural not illustrated conductor windings are arranged. The rotor 106 is fixedly connected to the main shaft 107 by means of a rotary bearing 108, which has a stationary ring 109 fixed to the stator 105 and a rotary ring (not represented) fixed to the rotor 106 the main shaft 17. In the embodiment of the attached figure 2, where the rotor 106 is externally arranged with respect to the stator 105, the stationary ring 109 is an inner ring of the rotary bearing 108 of the electric generator 100. An accelerometer 111 is fixed and mounted at any position on the stationary ring 109. The accelerometer 111 may be mounted for measurement of a vibration signal 202. The accelerometer 111 may be mounted for measurement of a vibration signal 202 in the tangential direction Z. According to another embodiment of the present invention, the accelerometer 111 may be mounted for measurement of a vibration signal in the radial direction Y. According to other embodiments of the present invention, the accelerometer 111 may be mounted on other locations on the stator 105, for example on the stator plates, which are normally provided at axial ends of the stator 105.

The electric generator 100 typically shows a cogging torque $T_{cog}$, which varies periodically within a mechanical period:

$$T_{cog} = \sum T_k \sin(mk\theta)$$

where m is the least common multiple of the number slots (Ns) and the number of poles (Np) of the stator 105, k is an integer varying between 1 and infinite, $T_k$ a plurality of constants depending on the geometry of the rotor 106 and the stator 105 and θ is the rotor mechanical position. The cogging torque $T_{cog}$ results from the airgap reluctance variation with rotor position, in other words from the interaction between magnets and stator teeth (when the stator 105 is unexcited). The vibration signal 202 is used according to the present invention as an input signal, which is a good representation of the cogging torque $T_{cog}$. This was confirmed by experimental observation.

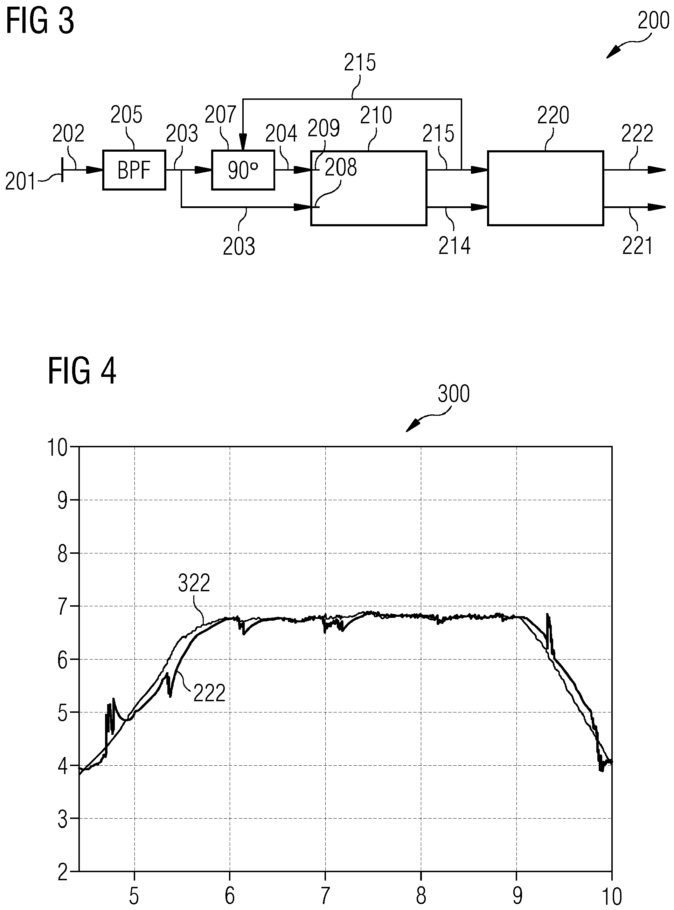

**Fig. 3** schematically illustrates a possible implementation of a hardware or logical circuit 200 and of a method for calculating position and/or speed of the rotor 103. The circuit 200 comprises an input port 201 for receiving the vibration input signal 202, measured by the accelerometer 111. The circuit 200 further includes a band-pass filter 205 connected to the input port 201 and receiving the vibration input signal 202 for generating as output a vibration filtered signal 203 at the frequency range of interest. The vibration filtered signal 203 is provided as input to a speed observer module 210 for generating as outputs a cogging position signal 214 and a cogging frequency signal 215. According to embodiments of the present invention, the speed observer module 210 may be a phase-locked loop (PLL). According to other embodiments of the present invention, another suitable circuit may be selected for calculating the cogging position signal 214 and the cogging frequency signal 215. The vibration filtered signal 203 is further provided to a phase shifter 207 receiving as further input the cogging frequency signal 215. The phase shifter 207 generates as output a phase shifted vibration signal 204. The speed observer module 210 comprises two input ports 208, 209 for respectively receiving the vibration filtered signal 203 and the shifted vibration signal 204. The shifted vibration signal 204 is shifted of 90° with respect to the vibration filtered signal 203. Alternatively, According to other embodiments of the present invention, the phase shifter 207 is not present and only the vibration filtered signal 203 is provided as input to the speed observer module 210. The circuit 200 further includes a rotor speed module 220 receiving the cogging position signal 214 and the cogging frequency signal 215 as inputs and generating a rotor position signal 221 and a rotor speed signal 222 as outputs. After obtaining the cogging position signal 214 and the cogging frequency signal 215, these are scaled in the rotor speed module 220 accordingly. A position offset may be added. The parameters for the operational steps to be performed in the rotor speed module 220 may be obtained by means of FEM simulation or experiments.

A comparison of experimental results 322 of the speed of the rotor 106 with the rotor speed signal 222 is shown in the diagram 300 of **Fig. 4**. It becomes evident that the present invention efficiently permits to substitute a directly measured speed of the rotor 106 with the estimated rotor speed signal 222. The same applies to the position of the rotor 106.

The logical circuit 200 may be activated when the electric generator 100 is in open circuit, i.e. when the electric generator 100 is below the so-called "cut-in speed" and the converter is switched off. The logical circuit 200 may be activated at the time when the connection between the electric generator 100 and the converter is required, i.e. at the cut-in speed or immediately before the "cut-in speed" is reached.

It should be noted that the term "comprising" does not exclude other elements or steps and "a" or "an" does not exclude a plurality. Also elements described in association with different embodiments may be combined. It should also be noted that reference signs in the claims should not be construed as limiting the scope of the claims.

## Claims

1. A circuit (200) for calculating position and/or speed of a rotor (103) of an electric generator (100), the circuit (200) comprising:

   an input port (201) for receiving a vibration input signal (202) representing a cogging torque of the electric generator (100),
   a speed observer module (210) connected to the input port (201) and generating a cogging position signal (214) and a cogging frequency signal (215) as outputs,
   a rotor speed module (220) receiving the cogging position signal (214) and the cogging frequency signal (215) as inputs and generating a rotor position signal (221) and a rotor speed signal (222) as outputs.

2. The circuit (200) according to claim 1, wherein the circuit (200) further includes a band-pass filter (205) connected between the input port (201) and the speed observer module (210).

3. The circuit (200) according to claim 1 or 2, wherein the speed observer module (210) is a phase-locked loop circuit module and the circuit (200) further includes a phase shifter (207) connected between the band-pass filter (205) and the speed observer module (210), the phase shifter (207) receiving as input the cogging frequency signal (215), the speed observer module (210) comprising two input ports (208, 209) respectively connected to the phase shifter (207) and the band-pass filter (205).

4. A wind turbine (10) comprising an electric generator (100) and a circuit (200) according to any of the previous claims.

5. A wind turbine (10) according to claim 4, wherein the wind turbine (10) includes an accelerometer (111) fixed with respect to a stator (105) of the electric generator (100), the accelerometer generating the vibration input signal (202).

6. A wind turbine (10) according to claim 5, wherein the accelerometer (111) is fixed to a stationary ring (109) of rotary bearing (108) of the electric generator (100).

7. A method of calculating position and/or speed of a rotor (103) of an electric generator (100), the method comprising:

   deriving a cogging torque signal of the electric generator (100) from an acceleration input signal (202),
   generating a cogging position signal (214) and a cogging frequency signal (215) based on the cogging torque signal,
scaling and/or off-setting the cogging position signal (214) and the cogging frequency signal (215) for generating a rotor position signal (221) and a rotor speed signal (222).

8. The method according to claim 7 wherein the cogging position signal (214) and the cogging frequency signal (215) are generated in a phase-locked loop circuit (210) receiving as input a filtered vibration input signal (203) and a second signal (204) having a phase shift with respect to the filtered vibration input signal (203).

9. The method according to claim 8, wherein the second signal (204) has a phase shift of 90° with respect to the filtered vibration input signal (203).

10. The method according to any of the claims 7 to 9, wherein the method activated when the electric generator (100) is in open circuit.

FIG 1

## FIG 2

FIG 3

FIG 4

Europäisches
Patentamt

European
Patent Office

Office européen
des brevets

## EUROPEAN SEARCH REPORT

Application Number

EP 19 17 2847

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | Rishabh Singh: "Novel Rotor Position Estimation Technique For Switched Reluctance Motor Using Vibration Signature Analysis", , 1 January 2015 (2015-01-01), XP055627736, Retrieved from the Internet: URL:https://pdfs.semanticscholar.org/b1ea/fddaff9ddbbd38a315fa528222e6a7cee288.pdf [retrieved on 2019-10-01] * abstract; figures 1,5 * * paragraphs III, IV, V * ----- | 1-10 | INV. H02P9/00 H02P6/18 ADD. H02P101/15 |
| Y | LING LUO ET AL: "Verification of permanent magnet synchronous generator for stand-alone wind power", ELECTRICAL MACHINES AND SYSTEMS (ICEMS), 2011 INTERNATIONAL CONFERENCE ON, IEEE, 20 August 2011 (2011-08-20), pages 1-4, XP032020180, DOI: 10.1109/ICEMS.2011.6073418 ISBN: 978-1-4577-1044-5 paragraphs I, II.A-C, III.A; * abstract; figures 1-2 * ----- | 1-10 | |
| Y | GALFARSORO UNAI ET AL: "Analysis of vibration induced by cogging torque in permanent-magnet synchronous motors", 2017 IEEE INTERNATIONAL WORKSHOP OF ELECTRONICS, CONTROL, MEASUREMENT, SIGNALS AND THEIR APPLICATION TO MECHATRONICS (ECMSM), IEEE, 24 May 2017 (2017-05-24), pages 1-6, XP033105821, DOI: 10.1109/ECMSM.2017.7945882 [retrieved on 2017-06-09] paragraphs I-III; * abstract; figure 1 * ----- -/-- | 1-10 | TECHNICAL FIELDS SEARCHED (IPC) H02P |

The present search report has been drawn up for all claims

| Place of search | Date of completion of the search | Examiner |
|---|---|---|
| Munich | 2 October 2019 | Landi, Matteo |

EPO FORM 1503 03.82 (P04C01)

Europäisches
Patentamt

European
Patent Office

Office européen
des brevets

# EUROPEAN SEARCH REPORT

Application Number

EP 19 17 2847

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | BECCUE P B ET AL: "A Coupled Piezoelectric/Single-Hall-Sensor Position Observer for Permanent Magnet Synchronous Machines", IEEE TRANSACTIONS ON INDUSTRIAL ELECTRONICS, IEEE SERVICE CENTER, PISCATAWAY, NJ, USA, vol. 54, no. 5, 1 October 2007 (2007-10-01), pages 2389-2397, XP011189308, ISSN: 0278-0046, DOI: 10.1109/TIE.2007.900323 * the whole document * ----- | 1-10 | |

TECHNICAL FIELDS
SEARCHED      (IPC)

The present search report has been drawn up for all claims

| Place of search | Date of completion of the search | Examiner |
|---|---|---|
| Munich | 2 October 2019 | Landi, Matteo |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)